# EUROPÄISCHE PATENTSCHRIFT

(11) **EP 3 030 536 B1**
(45) Veröffentlichungstag und Bekanntmachung des Hinweises auf die Patenterteilung: **23.05.2018**
(21) Anmeldenummer: 14731666.5
(22) Anmeldetag: 23.06.2014
(51) Int. Cl.: C04B 35/462, C04B 35/468, C04B 35/475, H01L 41/187

(54) **BLEIFREIER PIEZOKERAMISCHER WERKSTOFF AUF BISMUT-NATRIUM-TITANAT (BNT)-BASIS**
LEAD-FREE PIEZOCERAMIC MATERIAL BASED ON BISMUTH SODIUM TITANATE (BST)
MATIÈRE PIÉZOCÉRAMIQUE SANS PLOMB À BASE DE BISMUTH-SODIUM-TITANATE (BNT)

(30) Priorität: 07.08.2013 DE 102013013183; 16.06.2014 DE 102014211465
(43) Veröffentlichungstag der Anmeldung: 15.06.2016
(60) Teilanmeldung: 18164461.8
(73) Patentinhaber: PI Ceramic GmbH, 07589 Lederhose (DE)
(72) Erfinder: HENNIG, Eberhard, 07646 Mörsdorf (DE); KYNAST, Antje, 04275 Leipzig (DE); TÖPFER, Michael, 99310 Arnstadt (DE); HOFMANN, Michael, 07806 Neustadt an der Orla (DE)
(74) Vertreter: Kruspig, Volkmar
(86) Internationale Anmeldenummer: PCT/EP2014/063132
(87) Internationale Veröffentlichungsnummer: WO 2015/018558

(56) Entgegenhaltungen:
- JP-A- 2009 007 181
- JP-A- 2009 007 182
- DATABASE WPI Week 200874 Thomson Scientific, London, GB; AN 2008-M51161 XP002727700, -& CN 101 215 172 A (UNIV HUAZHONG SCI&TECHNOLOGY) 9. Juli 2008 (2008-07-09)
- MAZUMDER R ET AL: "Impedance and piezoelectric constants of phosphorous-incorporated Pb(Zr0.52Ti0.48)O3 ceramics", MATERIALS LETTERS, NORTH HOLLAND PUBLISHING COMPANY. AMSTERDAM, NL, Bd. 58, Nr. 25, 1. Oktober 2004 (2004-10-01), Seiten 3201-3205, XP004547930, ISSN: 0167-577X, DOI: 10.1016/J.MATLET.2004.06.011

## Beschreibung

Die Erfindung betrifft einen bleifreien piezokeramischen Werkstoff auf Bismut-Natrium-Titanat (BNT)-Basis einer definierten Grundzusammensetzung gemäß Oberbegriff des Anspruchs 1, und insbesondere einen im Sinne der RoHS Direktive (Richtlinie 2011/65/EU) bleifreien Werkstoffes mit einem Bleigehalt im homogenen Material < 0,1 Gew.-%.

Piezoaktoren, Piezosensoren und andere piezoelektrische Komponenten auf der Basis von Blei-Zirkonat-Titanat (PZT) stellen den derzeitigen Stand der Technik dar, wobei zunehmend die Forderung steht, piezokeramische Werkstoffe bleifrei auszugestalten.

In Weiterbildung des Standes der Technik wurden Versuche zu bleifreien piezokeramischen Werkstoffen auf der Basis BNT (Bismut-Natrium-Titanat) vorgenommen.

Diese Werkstoffe sind seit langem bekannt und grundlegende Zusammensetzungen sind in der JP 62202576 (BNT-BT und BNT-BKT) und der DE 19530592 C2 (BNT-BT-CT) beschrieben. Eine Modifikation dieser Werkstoffe mit bspw. Strontiumtitanat ist von Takenaka (Sensor and Materials; 3(1988)123-131) ausführlich beschrieben worden.

Aufbauend auf diesen grundlegenden Untersuchungen sind im Stand der Technik weitere Ausgestaltungen beschrieben worden. Diesbezüglich sei beispielsweise auf die US 2002/014196 A1, die EP 1231192 A1 verwiesen.

Ein grundlegendes Problem aller BNT-basierten Zusammensetzungen ist eine sehr schlechte Verdichtung beim Sintern und das Auftreten eines sogenannten Riesenkornwachstums verbunden mit einer hohen Leitfähigkeit. Piezokeramische Körper mit einem inhomogenen Gefüge lassen sich schlecht polarisieren, so dass die gewünschten Werkstoffeigenschaften nicht erreicht werden oder zu hohe Streuungen in den Werkstoffeigenschaften auftreten. Zur Unterdrückung des Riesenkornwachstums durch gezielte Substitution durch Mangan, Chrom, Eisen, Kobalt oder Niobat wurden Vorschläge in der JP 2004-075449 unterbreitet.

Eigene Untersuchungen bezüglich BNT-Werkstoffmodifizierungen mit Mangan und Kupfer zeigten zwar teilweise Verbesserungen im Sinterverhalten, jedoch eine nach wie vor ungebrochene Neigung zum Riesenkornwachstum und eine Verschlechterung elektrischer Daten.

Es verbleibt also festzuhalten, dass modifizierte BNT-Zusammensetzungen zu einem im Material inhomogen verteilten Riesenkornwachstum beziehungsweise zur Ausbildung von einem grobkörnigen Gefüge neigen. Dabei ist das Auftreten von Riesenkörnern unkontrollierbar und hängt stark von den Aufbereitungs- und Sinterbedingungen ab. Das Kornwachstum kann zwar durch niedrige Sintertemperaturen unterdrückt werden, was allerdings zu einer nur geringen Sinterdichte von <5,6 g/cm3 führt. Die Folgen des unerwünschten Riesenkornwachstums beziehungsweise des grobkörnigen Gefüges sind ein niedriger und stark temperaturabhängiger spezifischer elektrischer Isolationswiderstand, eine schlechte Polarisierbarkeit der keramischen Körper und ein gestörtes Schwingungsverhalten der Dickenschwingung im Megahertzbereich.

Bei eigenen Untersuchungen wurde darüber hinaus gefunden, dass der Leckstrom extrem vom Gefüge und der Temperatur abhängig ist.

Im Übrigen ist festzustellen, dass modifizierte BNT-Zusammensetzungen oftmals ein kleines Sinterintervall aufweisen, was zu technologisch schwer beherrschbaren Problemen führt. Unter Sinterintervall ist der durch zwei Temperaturangaben eingegrenzte Bereich zu verstehen, innerhalb dessen beim Brennen des Werkstoffes die erforderlichen Eigenschaften der Keramik erzielt werden. Ein kleines Sinterintervall führt somit dazu, dass die erwünschten Eigenschaften der piezokeramischen Werkstoffe nur erreicht werden, wenn beim Brennen mit sehr kleinen Temperaturtoleranzen gearbeitet werden kann, was technologisch schwer beherrschbar ist. Ein kleines Sinterintervall führt somit zu wirtschaftlichen Nachteilen, da ein relativ hoher Anteil der Produktion Ausschuss ist.

Aus dem Vorgenannten ist es daher Aufgabe der Erfindung, einen bleifreien piezokeramischen Werkstoff auf BNT-Basis anzugeben, welcher ein homogenes, feinkörniges Gefüge zeigt und einen spezifischen elektrischen Isolationswiderstand bei einer Temperatur von 150°C von ≥ 5*10⁸ Ωm aufweist. Eine weitere Aufgabe der Erfindung bestand darin, einen bleifreien piezokeramischen Werkstoff auf BNT-Basis anzugeben, welcher ein großes Sinterintervall aufweist, insbesondere ein Sinterintervall von ≥ 40 K.

Die Lösung der Aufgabe der Erfindung erfolgt durch die Merkmalskombination nach Anspruch 1, sowie ein Verfahren zur Herstellung eines dementsprechenden piezokeramischen Werkstoffs und durch einen auf der Basis des erfindungsgemäßen Werkstoffs hergestellten piezokeramischen Körpers oder Multilayeraktors.

Es wird demnach von einem bleifreien piezokeramischen Werkstoff auf Bismut-Natrium-Titanat-Basis der Grundzusammensetzung

| | |
|---|---|
| x(Bi_{0,5}Na_{0,5})TiO₃ - yBaTiO₃ - zSrTiO₃ | mit x+y+z = 1 |
| und | 0<x<1, 0<y<1, 0≤z≤0,07 |
| bevorzugt | 0<x<1, 0,1<y<0,25, 0≤z≤0,07 |
| mehr bevorzugt | 0<x<1, 0,1≤y≤0,20, 0≤z≤0,03 |

oder

| | |
|---|---|
| x(Bi_{0,5}Na_{0,5})TiO₃ - yBaTiO₃ - zCaTiO₃ | mit x+y+z = 1 |
| und | 0<x<1, 0<y<1, 0<z≤0,05 |
| bevorzugt | 0<x<1, 0,1<y<0,25, 0<z≤0,05 |
| mehr bevorzugt | 0<x<1, 0,1≤y≤0,20, 0<z≤0,02 |

ausgegangen.

Durch Zugabe eines phosphorhaltigen Materials in einer solchen Menge, dass die Konzentration von Phosphor im piezokeramischen Werkstoff bei 250 bis 2000 ppm liegt, wird ein erfindungsgemäßer piezokeramischer Werkstoff erhalten.

Erfindungsgemäß wird die Aufgabe gelöst durch einen bleifreien piezokeramischen Werkstoff auf Bismut-Natrium-Titanat (BNT)-Basis der Grundzusammensetzung

| | |
|---|---|
| x(Bi_{0,5}Na_{0,5})TiO₃ - yBaTiO₃ - zSrTiO₃ | mit x+y+z = 1 |
| und | 0<x<1, 0<y<1, 0≤z≤0,07 |
| bevorzugt | 0<x<1, 0,1<y<0,25, 0≤z≤0,07 |
| mehr bevorzugt | 0<x<1, 0,1≤y≤0,20, 0≤z≤0,03 |

oder

| | |
|---|---|
| x(Bi_{0,5}Na_{0,5})TiO₃ - yBaTiO₃ - zCaTiO₃ | mit x+y+z = 1 |
| und | 0<x<1, 0<y<1, 0<z≤0,05 |
| bevorzugt | 0<x<1, 0,1<y<0,25, 0<z≤0,05 |
| mehr bevorzugt | 0<x<1, 0,1≤y≤0,20, 0<z≤0,02 |

**gekennzeichnet durch**
die Zugabe eines phosphorhaltigen Materials in einer solchen Menge, dass die Konzentration von Phosphor im piezokeramischen Werkstoff bei 250 bis 2000 ppm liegt.

Die Angabe ppm (parts per million) bezieht sich dabei auf die Masse an Phosphor bezogen auf die Gesamtmasse der piezokeramischen Zusammensetzung.

In einer bevorzugten Ausführungsform weist der erfindungsgemäße piezokeramische Werkstoff einen Bleigehalt von <0,1 Gew.-% auf.

In einer bevorzugten Ausführungsform ist der erfindungsgemäße piezokeramische Werkstoff auf Bismut-Natrium-Titanat (BNT)-Basis so ausgestaltet, dass er die Grundzusammensetzung
x(Bi_{0,5}Na_{0,5})TiO₃ - yBaTiO₃ - zSrTiO₃ mit y ≥ 0,1 und x+y+z = 1 oder x(Bi_{0,5}Na_{0,5})TiO₃ - yBaTiO₃ - zCaTiO₃ mit y ≥ 0,1 und x+y+z = 1 aufweist, wobei eine Zugabe eines phosphorhaltigen Materials in einer solchen Menge erfolgt, dass die Konzentration von Phosphor im piezokeramischen Werkstoff bei 250 bis 2000 ppm liegt.

Bei einer bevorzugten Ausführungsform ist der bleifreie piezokeramische Werkstoff so ausgestaltet, dass die phosphorhaltige Verbindung ein anorganisches Phosphat, Hydrogenphosphat oder Dihydrogenphosphat ist.

Bei einer besonders bevorzugten Ausführungsform ist der bleifreie piezokeramische Werkstoff so ausgestaltet, dass die phosphorhaltige Verbindung ausgewählt ist aus der Gruppe, die aus KH₂PO₄ (KDP), (NH₄)H₂PO₄ (ADP) besteht.

Während der erfindungsgemäße Effekt der Zugabe des phosphorhaltigen Materials in einem breiten Mengenbereich erreicht wird, hat es sich gezeigt, dass besonders vorteilhafte Eigenschaften erzielt werden, wenn der bleifreie piezokeramische Werkstoff so ausgestaltet ist, dass das phosphorhaltige Material in einer solchen Menge zugegeben wird, dass die Konzentration von Phosphor in dem bleifreien piezokeramischen Werkstoff 250 bis 2000 ppm beträgt.

Es hat sich gezeigt, dass bei Überschreiten der Konzentration von Phosphor in dem erfindungsgemäßen keramischen Werkstoff von 2000 ppm eine schlechtere Verarbeitbarkeit der Materialmischung zu dem piezokeramischen Werkstoff eintritt. Das phosphorhaltige Material wird in einer solchen Menge eingesetzt, dass die Konzentration von Phosphor in dem bleifreien piezokeramischen Werkstoff 250 bis 2000 ppm, stärker bevorzugt 270 bis 1800 ppm beträgt.

Es hat sich gezeigt, dass die Eigenschaften des bleifreien piezokeramischen Werkstoffs in besonders vorteilhafter Weise beeinflusst werden können, indem die Grundzusammensetzung Zusätze in Form von Oxiden oder komplexer Perowskite enthält.

In überraschender Weise gelingt es mit dem erfindungsgemäßen bleifreien piezokeramischen Werkstoff, das Sinterintervall auf ≥40 K einzustellen.

Die Erfindung betrifft auch ein Verfahren zu Herstellung der verschiedenen bleifreien piezokeramischen Werkstoffe. Das erfindungsgemäße Verfahren ist vorzugsweise so ausgestaltet, dass es die folgenden Schritte umfasst:
- Herstellung einer Rohstoffmischung der Grundzusammensetzung,
- Herstellung eines Kalzinats der Grundzusammensetzung
- Feinmahlung des Kalzinats
- Herstellung eines Granulats insbesondere durch Sprühgranulierung oder Herstellung eines Gießschlickers für den Multilayer oder
   "Co-firing" Prozess
- Weiterverarbeitung in bekannter Weise einschließlich Sinterung in normaler Atmosphäre.

Unter "Co-firing" Prozess ist im Sinne der vorliegenden Erfindung ein besonders innovatives Herstellungsverfahren zu verstehen, bei dem zunächst Folien aus Piezokeramikmaterial gegossen und anschließend noch im Grünzustand mit Elektroden versehen werden . Aus vielen Einzelfolien wird ein Piezoelement laminiert und anschließend gemeinsam mit den Innenelektroden in einem einzigen Prozessschritt gesintert, wie beispielsweise in der DE 10234787 beschrieben.

Die Zugabe von Phosphor oder phosphorhaltigen Materialien kann bei der Feinmahlung und/oder der Aufbereitung eines Sprühschlickers oder Gießschlickers erfolgen.

Das erfindungsgemäße Verfahren ist in besonders bevorzugter Weise so ausgestaltet, dass die Zugabe von Phosphor oder phosphorhaltigen Materialien bei der Aufbereitung des Sprüh- oder Gießschlickers erfolgt. Dieses Verfahren hat den Vorteil, dass zunächst eine großtechnische Herstellung eines feingemahlenen Pulvers der Grundzusammensetzung erfolgt und die Menge und Art der Phosphorzugabe an die Erfordernisse der nachfolgenden Prozessschritte (Sprühschlicker, Gießschlicker) angepasst werden kann.

In einem besonders bevorzugten Verfahren zur Herstellung des erfindungsgemäßen bleifreien piezokeramischen Werkstoffs wird zunächst ein Kalzinat der Grundzusammensetzung bereitgestellt. Dann erfolgt eine Zugabe von Phosphor vorzugsweise in Form von KDP oder ADP, welche als Einkristall ferroelektrisch sind, in einer Konzentration von 270 bis 1800 ppm. Die Zugabe kann bei der Feinvermahlung oder beim Aufbereiten des Sprühschlickers oder Gießschlickers erfolgen. Die Weiterverarbeitung des derartigen Materials einschließlich Sinterung in normaler Atmosphäre erfolgt gemäß bekannten Technologien.

Erfindungsgemäß ist darüber hinaus ein piezokeramischer Multilayeraktor auf der Basis des vorbeschriebenen piezokeramischen Werkstoffs. Ein solcher piezokeramischer Multilayeraktor ist bspw. aus der DE 10234787 oder der DE 20 2012012009 bekannt.

Die Erfindung bezieht sich auch auf ein piezoelektrisches Bauelement auf Basis des vorbeschriebenen piezokeramischen Werkstoffs, das aus mindestens einem piezokeramischen Körper mit mindestens zwei Elektroden besteht und insbesondere auch auf einen piezoelektrischen Ultraschallwandler, der insbesondere in seiner Dickenschwingung betrieben wird.

Das eingesetzte phosphorhaltige Material kann als Sinterhilfsmittel verstanden werden, wobei es hier maßgeblich auf die Phosphorkomponente ankommt. Mit der gezielten Zugabe von Phosphor zur BNT-Grundzusammensetzung wird das Vorurteil der Fachwelt überwunden, wonach Phosphor - obwohl es zwar in positiver Weise das Kornwachstum hemmt- die piezoelektrischen Eigenschaften entsprechender piezokeramischer Werkstoffe verschlechtert.

Überraschend hat sich gezeigt, dass durch den Einsatz des phosphorhaltigen Materials nicht nur eine wirksame Unterdrückung des Riesenkornwachstums und damit ein homogenes, feinkörniges Gefüge erzielt werden kann, sondern gleichzeitig auch ein breites Sinterintervall von ≥ 40K des piezokeramischen Werkstoffs erzielt wird. Dies ist technologisch von großer Bedeutung, da ein breites Sinterintervall Voraussetzung für eine kosteneffektive Herstellung des Materials, Multilayeraktors oder Bauelementes ist. Darüber hinaus weisen die erfindungsgemäßen piezokeramischen Werkstoffe einen hohen spezifischen elektrischen Isolationswiderstand von ≥ 5*10⁸ Ωm bei 150°C auf, was für den Einsatz in den beschriebenen Bauelementen sehr vorteilhaft ist.

Es ergibt sich bei dem erfindungsgemäßen piezokeramischen Werkstoff ein homogenes, feinkörniges Gefüge in einem breiten Sinterintervall von≥ 40K, im Temperaturbereich von 1120°C bis 1240°C. Als Vorteile sind darüber hinaus eine Erhöhung des Isolationswiderstands bei hohen Temperaturen und damit ein besseres Polarisationsverhalten festzustellen. Ein auf der Basis des bleifreien piezokeramischen Werkstoffs gemäß der Erfindung hergestellter Aktor weist eine hohen Isolationswiderstand über einen weiten Temperaturbereich auf, während ein erfindungsgemäßer Ultraschallwandler eine ausgeprägte Dickenschwingung mit hohem Kopplungsfaktor aufweist.

Es verbleibt festzustellen, dass in überraschender Weise der Einsatz phosphorhaltiger Zusätze zu einer Hemmung des Riesenkornwachstums und zu einem homogenen, feinkörnigen Gefüge führt, und dass durch Art und Menge der Phosphorzugabe die Lage der Depolarisationstemperatur in gewissen Grenzen beeinflusst werden kann.

Phosphorhaltige Zusätze können bei der Feinvermahlung oder der Sprühgranulierung zugegeben werden. Denkbar ist aber auch die Verwendung phosphorhaltiger Dispergatoren und/oder Zusätze bei der Aufbereitung von Gießschlickern bzw. die Verwendung phosphorhaltiger Bindemittel bei der Aufbereitung derartiger Schlicker.

Bei geeigneter Wahl der phosphorhaltigen Dispergatoren und/oder Zusätze ergibt sich der technologische Vorteil, dass die Viskosität von Feinmahl-, Gieß- bzw. Sprühschlicker nicht negativ beeinflusst wird.

Zusätzlich kann mit einem Phosphoreintrag gearbeitet werden, der wesentlich über dem durch übliche Rohstoffverunreinigung und übliche Dispergator-Konzentrationen eingetragenen Wert liegt und bei der die zugegebene Phosphormenge gezielt eingestellt werden kann.

Eine mögliche Alternative ist der Phosphorzusatz bei der Rohstoffmischung oder eine Infiltration von Festkörpern mit phosphorhaltigen Flüssigkeiten.

Es hat sich gezeigt, dass der Zusatz des Phosphors zu dem erfindungsgemäßen Material in Form eines nahezu beliebigen phosphorhaltigen Materials erfolgen kann. Wenn auch Kaliumdihydrogenphosphat oder Ammoniumdihydrogenphosphat besonders bevorzugte phosphorhaltige Materialien sind, kann die Zugabe von Phosphor auch durch beliebige andere phosphorhaltige Materialien erfolgen.

Durch ihre Untersuchungen haben die Erfinder der vorliegenden Anmeldung festgestellt, dass mit der Zugabe des phosphorhaltigen Materials eine gewisse Absenkung der Depolarisationstemperatur einhergeht. Der Effekt der Absenkung der Depolarisationstemperatur ist dabei für unterschiedliche phosphorhaltige Materialien verschieden. So hat sich gezeigt, dass beispielsweise bei Zugabe von Ammoniumdihydrogenphosphat ein wesentlich stärkerer Abfall der Depolarisationstemperatur eintritt als bei Zugabe von Kaliumdihydrogenphosphat. Dieser unerwartete Effekt führt dazu, dass die vorliegende Erfindung den weiteren Vorteil aufweist, dass durch die Auswahl des zusätzlichen phosphorhaltigen Materials bei ansonsten gleichbleibenden Eigenschaften des piezokeramischen Materials die Absenkung der Depolarisationstemperatur in gewissen Grenzen gesteuert werden kann. Dies ist deshalb von Bedeutung, weil in Abhängigkeit vom gewünschten Einsatzzweck des piezokeramischen Materials eine bestimmte Depolarisationstemperatur angestrebt wird. Während es im Allgemeinen wünschenswert erscheint, eine möglichst geringe Absenkung der Depolarisationstemperatur anzustreben, kann es für bestimmte Anwendungen durchaus nützlich sein, eine stärkere Absenkung der Depolarisationstemperatur zu erreichen. Dies gilt insbesondere für Einsatzzwecke, bei denen die piezokeramischen Materialien nur in einem sehr engen Temperaturintervall funktionsfähig sein müssen. Für solche Anwendungen kann es durchaus sinnvoll sein, eine stärkere Absenkung der Depolarisationstemperatur anzustreben, da sich die wünschenswerten piezoelektrischen Eigenschaften der piezokeramischen Materialien bei der Annäherung an die Depolarisationstemperatur von unten verbessern.

Die Erfindung betrifft darüber hinaus auch die Verwendung eines phosphorhaltigen Materials in einem piezokeramischen Werkstoff auf Bismut-Natrium-Titanat (BNT)-Basis der oben genannten Grundzusammensetzung zur Verminderung des Riesenkornwachstums und zur Erzielung eines homogenen, feinkörnigen Gefüges, wobei das phosphorhaltige Material in einer solchen Menge eingesetzt wird, dass die Konzentration von Phosphor im piezokeramischen Werkstoff bei bei 250 bis 2000 ppm, stärker bevorzugt 270 bis 1800 ppm liegt

Die Erfindung soll nachstehend anhand eines Ausführungsbeispiels und der Darstellung von Vergleichsversuchen näher erläutert werden.

### Beispiele

Die im Folgenden angeführten Messergebnisse beziehen sich auf das Grundsystem **x(Bi0,5Na0,5)TiO3** - **yBaTiO₃** - **zSrTiO3.**

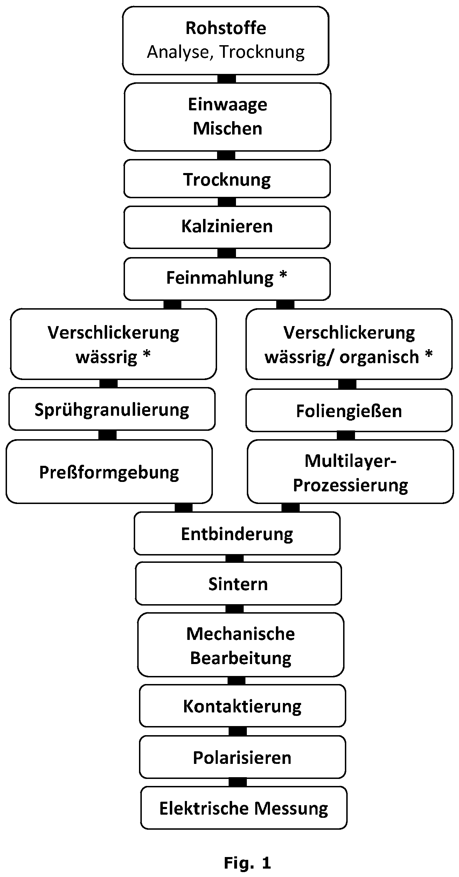

**Figur 1** beschreibt den allgemeinen technologischen Ablauf der Probenherstellung. Mit "*" sind diejenigen technologischen Schritte gekennzeichnet, in denen der in den Ansprüchen beschriebene Zusatz phosphorhaltiger Materialien erfolgen kann.

Die Mischung der Rohstoffe und die Feinmahlung des Kalzinats erfolgten jeweils in einer Rührwerkskugelmühle.

Phosphorhaltige Zusätze erfolgten konkret bei folgenden technologischen Schritten:
- FM: Feinmahlung
- G: Zusatz bei der Granulierung
- VS: Zusatz bei der organischen Verschlickerung zur Folienherstellung

Die Gefügecharakterisierung erfolgte nach folgender Klassifizierung:
- 0: Material nicht prozessierbar
- 1: feinkörniges, homogenes Gefüge
- 2: inhomogenes Gefüge, Riesenkornwachstum
- 3: grobkörniges Gefüge

Die Probendichte wurde an gesinterten Zylindern nach der Auftriebsmethode bestimmt und wird entweder als Mittelwert für die angegebene Sintertemperatur angegeben oder als "Dichte in g/cm3 >" für die niedrigste Sintertemperatur mit messbaren elektrischen Werten im angegebenen Temperaturbereich.

Für die elektrischen Messungen wurden metallisierte Proben mit einem Durchmesser von 12mm, einem Isolationsrand von 0,5mm und einer Dicke von 0,5mm verwendet. Die Polung erfolgte bei 80°C, 15min, 5kV/mm.

"S" kennzeichnet Proben mit starker Streuung der Messwerte, Störung der Resonanzkurven bzw. zu niedrigem maximalen Phasenwinkel in der Radial- bzw. Dickenschwingung.

**kₚ** bzw. **kₜ** sind die Kopplungsfaktoren der Radial- bzw. Dickenschwingung.

Die Depolarisationstemperatur **T_{d}** wird im Allgemeinen als Wendepunkt in der Temperaturabhängigkeit der Dielektrizitätszahl von gepolten Proben definiert.

Der spezifische Isolationswiderstand **ρᵢₛ** wird bei 50V an gepolten Proben bei Temperaturerhöhung von Raumtemperatur bis 200°C bestimmt.

Die elektromechanische Dehnung **S₃** wird mittels Laserinterferometer bei 2kV/mm bestimmt. In der Tabelle werden der Wert bei Raumtemperatur und der dazugehörige Probenstrom **I** angegeben.

In **Tabelle 2** sind charakteristische Werte im untersuchten Temperaturbereich dargestellt.

Die Diagramme und lichtmikroskopischen Gefügeaufnahmen beziehen sich auf die in den Tabellen unter der jeweiligen Probennummer definierte Zusammensetzung.

Im Folgenden soll der **Stand der Technik und die zu beseitigenden Mängel** näher beschrieben werden:

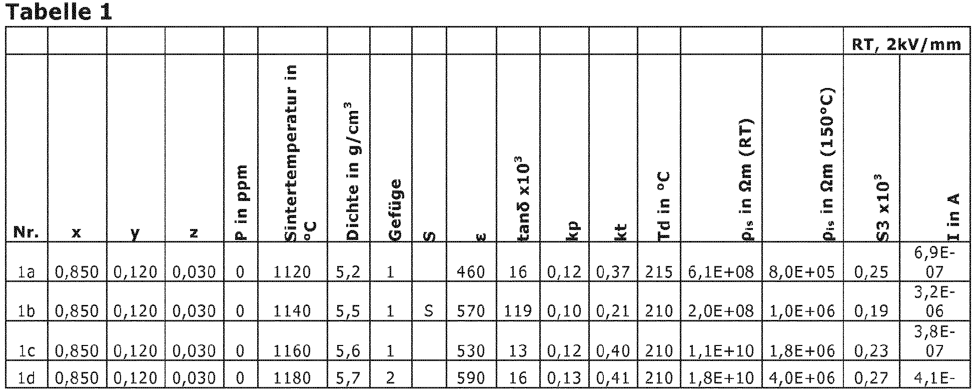

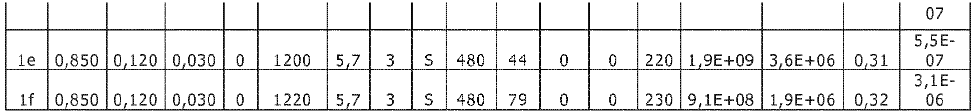

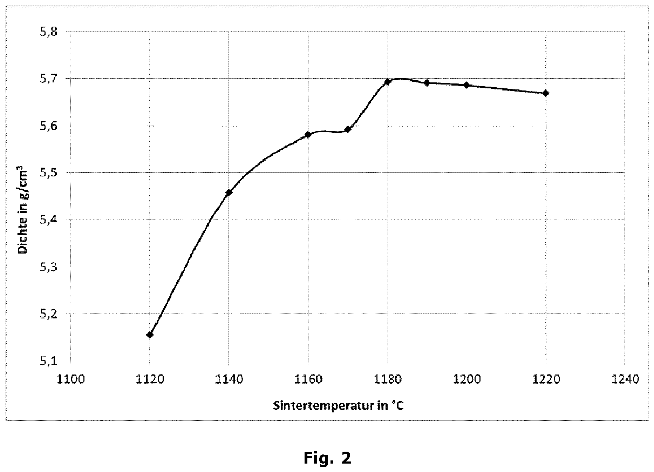

**Figur 2****,** Proben 1a bis 1f aus Tab.1, zeigt den Verlauf der Sinterdichte für die Grundzusammensetzung **0,85(Bi0,5Na0,5)TiO3** - **0,12BaTiO3 -0,03SrTiO3** in Abhängigkeit von der Sintertemperatur. Charakteristisch ist die geringe Dichte bei niedrigen Sintertemperaturen, das enge Sinterintervall und der durch die Zersetzung der Proben (Verdampfung Bi, Na) bedingte Abfall der Dichte bei hohen Sintertemperaturen.

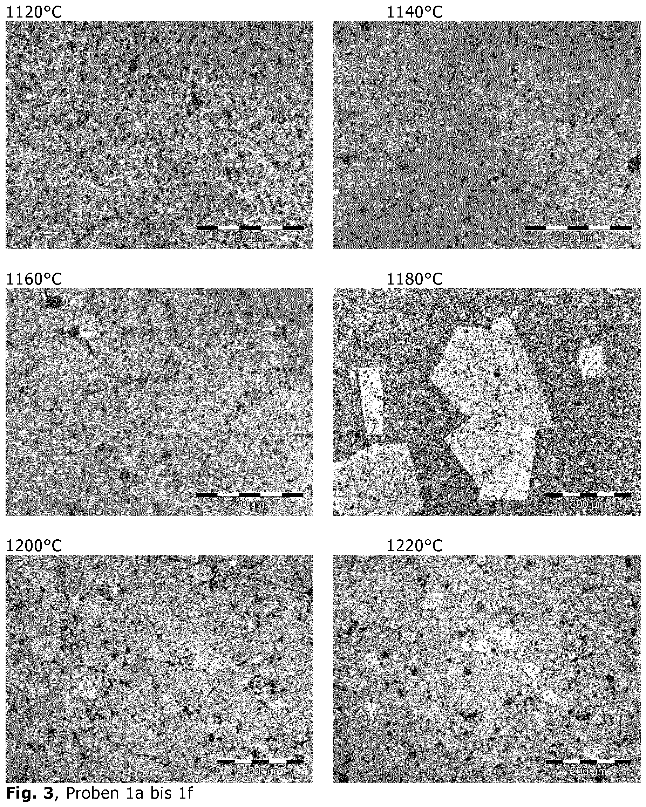

Die entsprechenden lichtmikroskopischen Gefügeaufnahmen (**Fig. 3**) zeigen den Übergang vom feinkörnigen, unzureichend verdichteten Material zum Riesenkornwachstum in der Mitte des untersuchten Temperaturbereichs und zu grobkörnigem Gefüge bei höheren Sintertemperaturen.

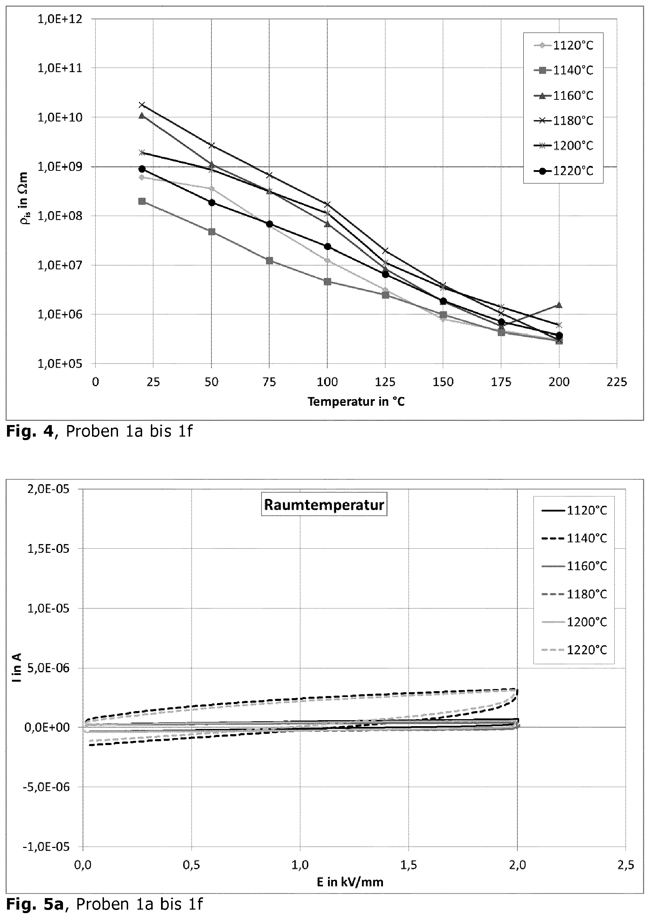

Nachteilig erweist sich der extreme Abfall des Isolationswiderstandes mit der Probentemperatur (**Figur 4****,** Proben 1a bis 1f). Die Folge sind eine unzureichende bzw. undefinierte Polung und zu niedrige bzw. stark streuende elektrische Werte.

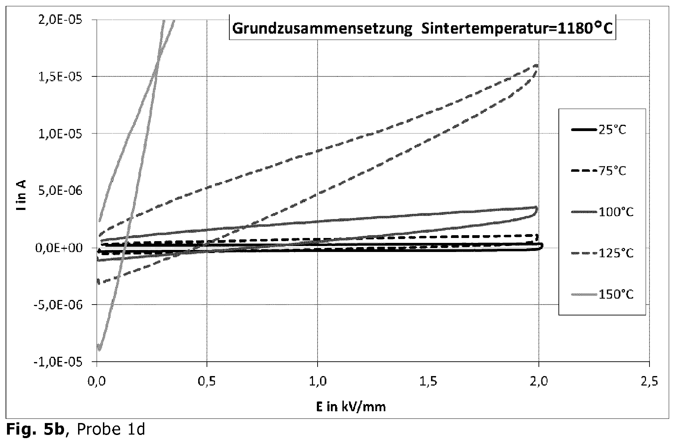

Deutlich erkennbar ist die nicht tolerierbare elektrische Leitfähigkeit in der Darstellung des Probenstroms bei höheren elektrischen Feldstärken und höheren Temperaturen (**Fig. 5a****,** Proben 1a bis 1f, **5b,** Probe 1d). Die Arbeitstemperatur von Aktoren wird dadurch erheblich eingeschränkt.

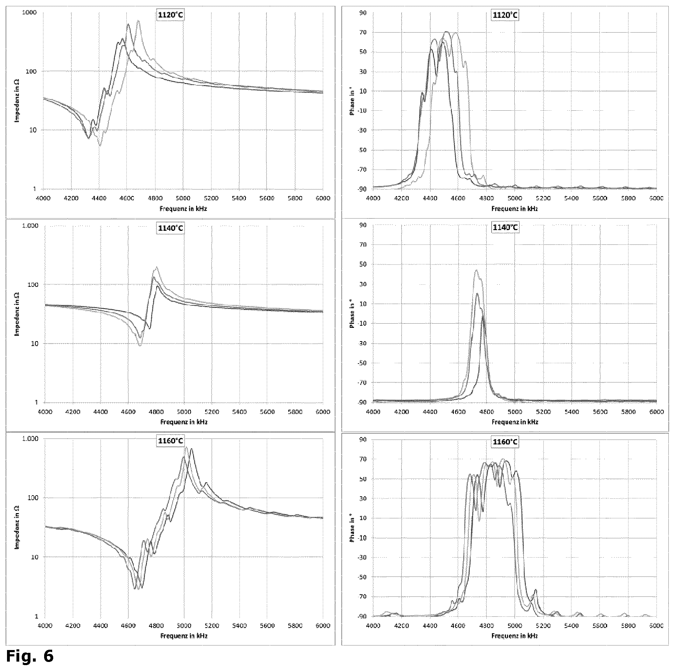

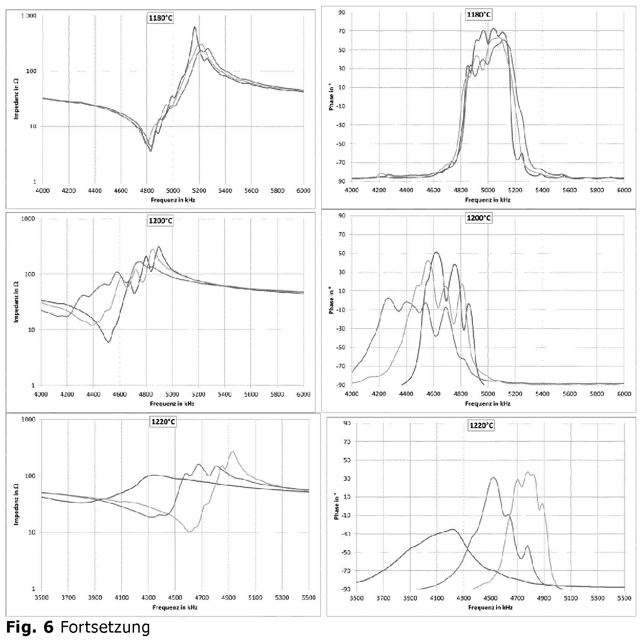

Die Darstellung des Verlaufs von Impedanz und Phase der Dickenschwingung für die bei unterschiedlicher Temperatur gesinterten Proben (**Fig. 6****,** Proben 1a bis 1f) offenbart einen Zusammenhang zwischen Gefüge und Resonanzverhalten (dargestellt sind jeweils 3 Einzelproben). Das Material ist gekennzeichnet durch
- eine starke Streuung der Kurvenverläufe bei der jeweiligen Sintertemperatur,
- eine starke Streuung der Kurvenverläufe bei Variation der Sintertemperatur und
- extrem gestörtes Resonanzverhalten bei höheren Sintertemperaturen.

Die Daten sind in der **Tabelle 1** zusammengefasst.

Es zeigt sich somit, dass keine der angewandten Sintertemperaturen zu hinreichend guten und reproduzierbaren elektrischen bzw. elektromechanischen Werten führt und die bisherige Technologie nicht für eine großtechnische Produktion geeignet ist.

Ein vergleichbares Verhalten zeigen die in der **Tabelle 2** angeführten, nicht in den Anspruchsbereich fallenden Proben 2a, 5a, 9a, 10a, 14 und 15.

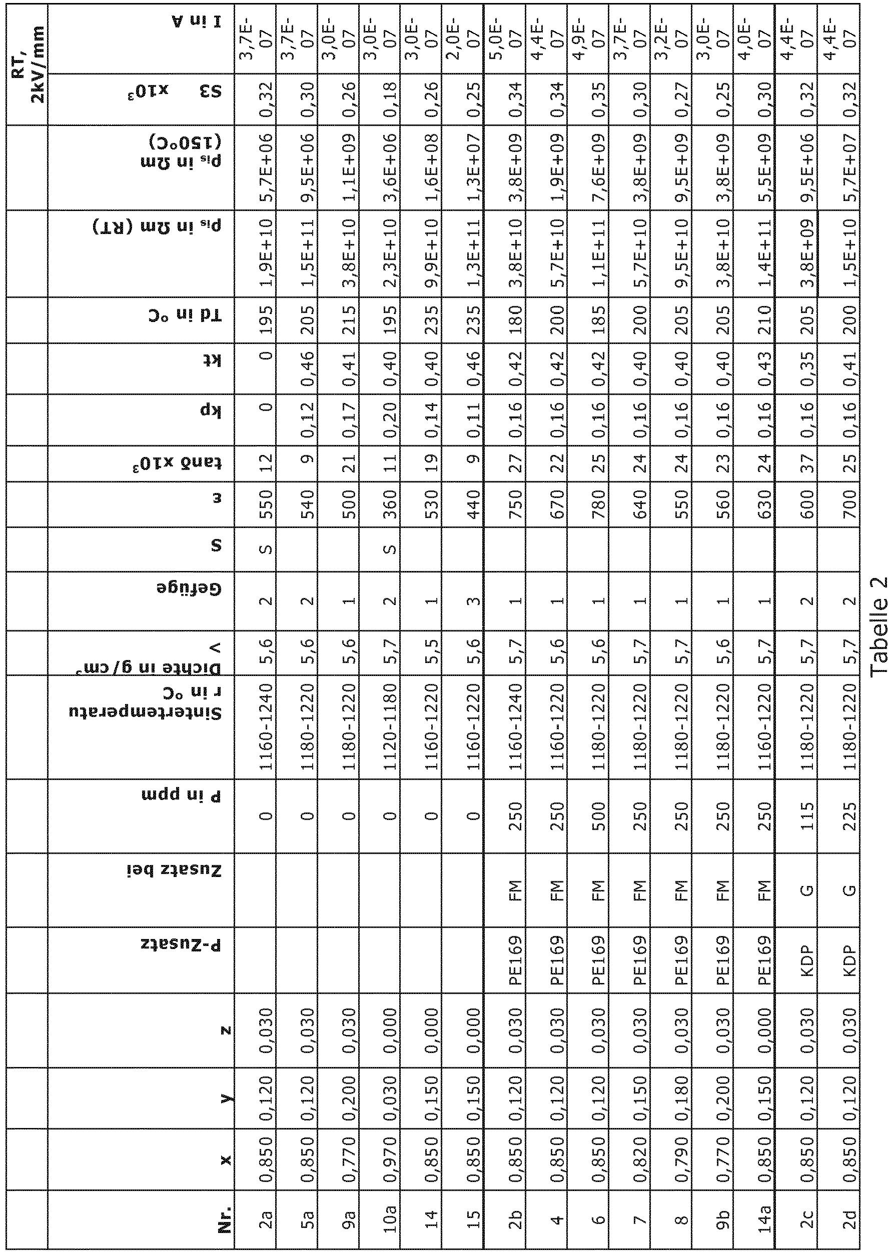

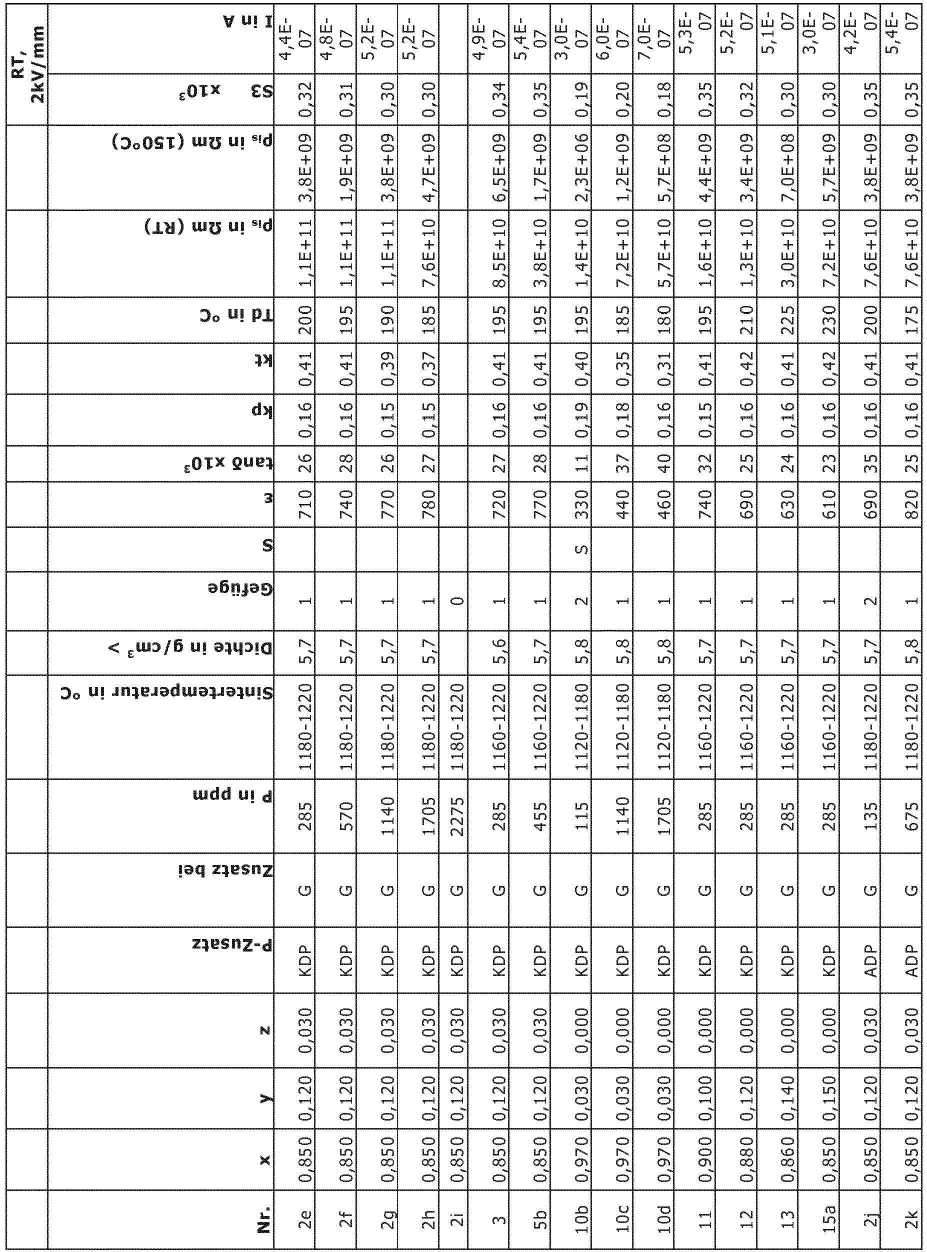

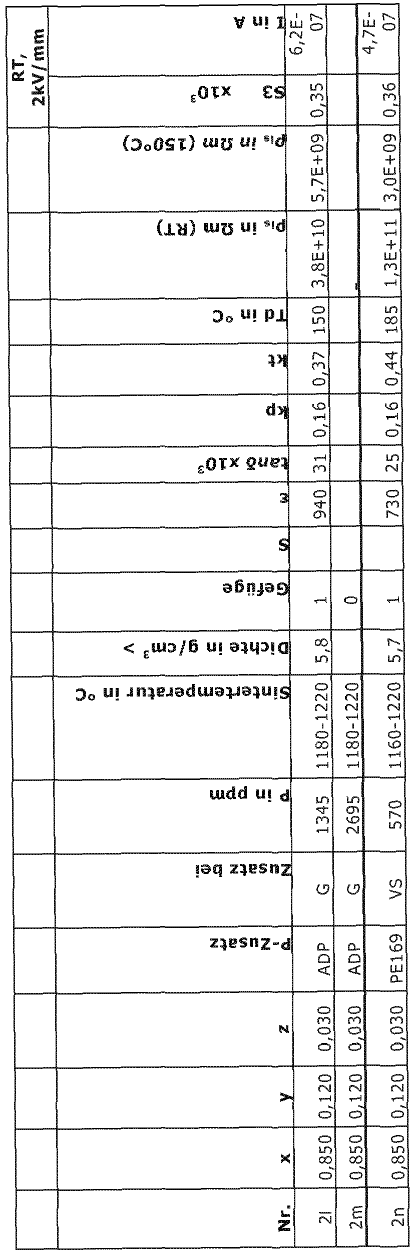

Die nachfolgenden Ausführungsbeispiele zeigen das Verhalten erfindungsgemäß hergestellter Zusammensetzungen.

### Ausführungsbeispiel 1:

Die Grundzusammensetzung **0,85(Bi0,5Na0,5)TiO3** - **0,12BaTiO3 -0,03SrTiO3** wurde gemäß des Flußdiagramms (**Fig.1**) prozessiert und
- entweder ein phosphorhaltiger Dispergator bei der Feinmahlung zugesetzt (PE169, Hersteller Akzo Nobel)
- oder Kaliumdihydrogenphosphat bei der Granulierung durch Zusatz zum Bindemittel eingebracht.

Proben 2i mit 2275ppm P (KDP) bzw. 2m mit 2695ppm P (ADP) waren auf diese Weise nicht prozessierbar.

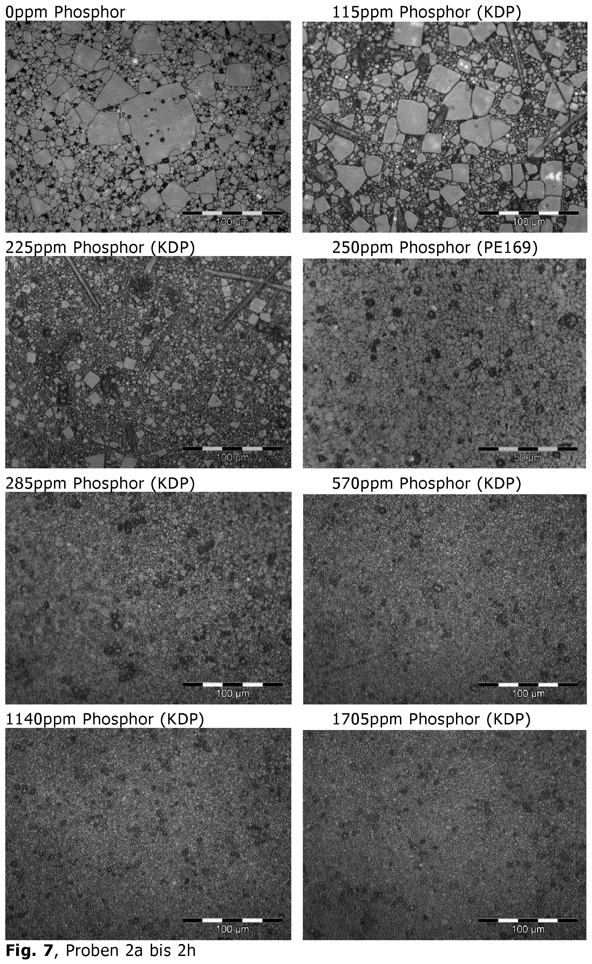

Wie die lichtmikroskopischen Gefügeaufnahmen (**Figur 7****,** Proben 2a bis 2h) erkennen lassen, bewirkt ein erfindungsgemäßer Zusatz an Phosphor **≥250ppm** die Erzeugung eines homogenen, feinkörnigen Gefüges.

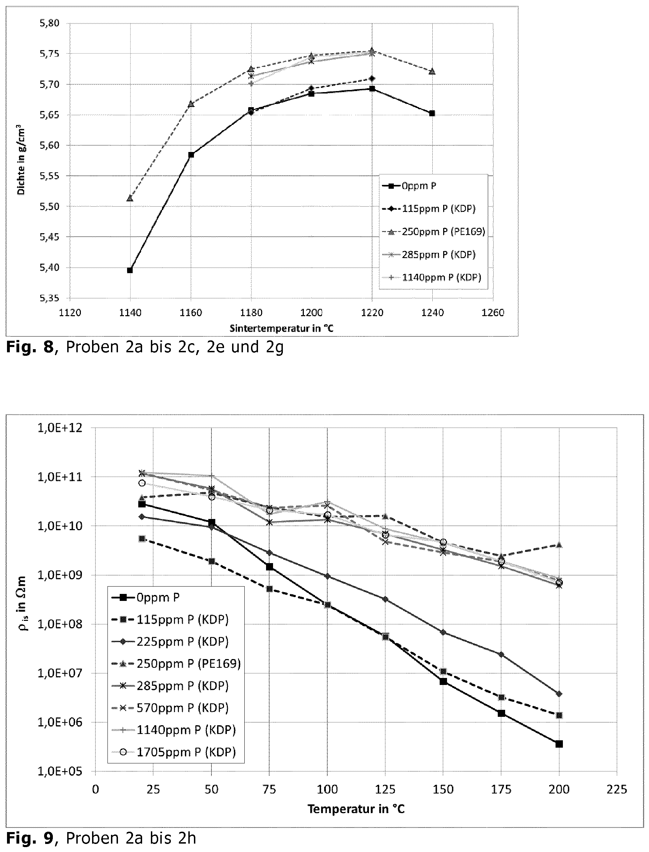

**Figur 8** (Proben 2a, 2b, 2c, 2e und 2g) zeigt eine deutliche Verbesserung der Verdichtung bei Zusatz von erfindungsgemäßen Mengen an Phosphor **≥250ppm.**

Außerdem zeigt sich überraschenderweise eine erhebliche Erhöhung des spezifischen Isolationswiderstandes bei höheren Temperaturen um mehrere Größenordnungen (**Figur 9****,** Proben 2a bis 2h). Dadurch wird ab 250ppm Phosphor eine ausreichend gute, reproduzierbare Polung der Proben gewährleistet.

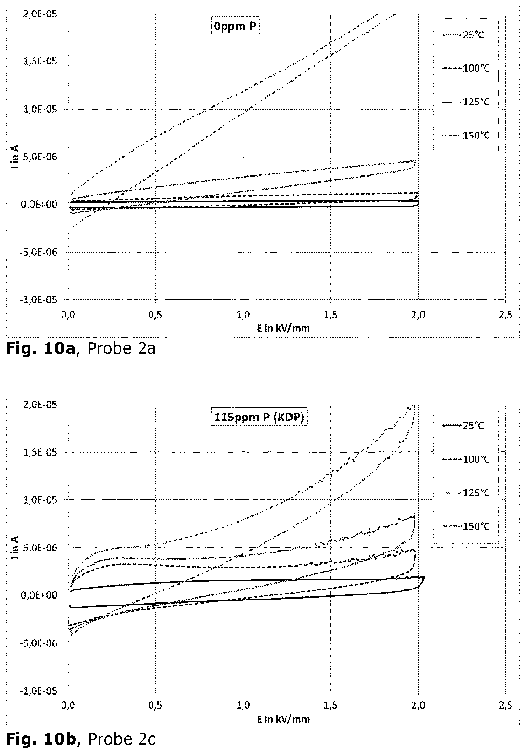

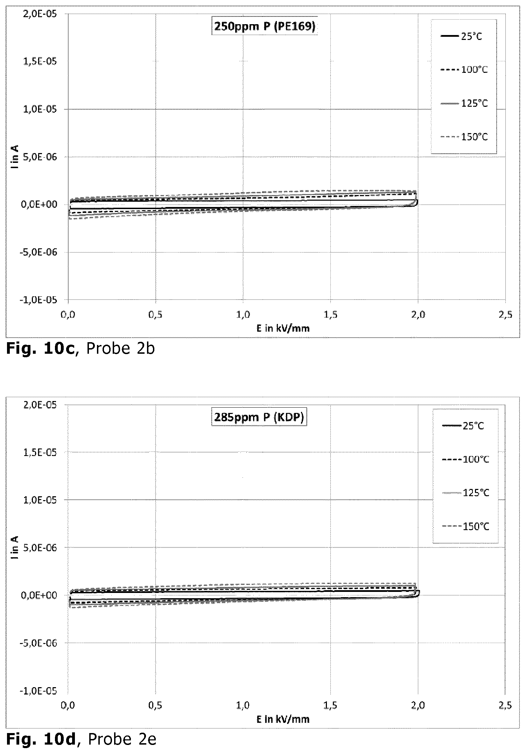

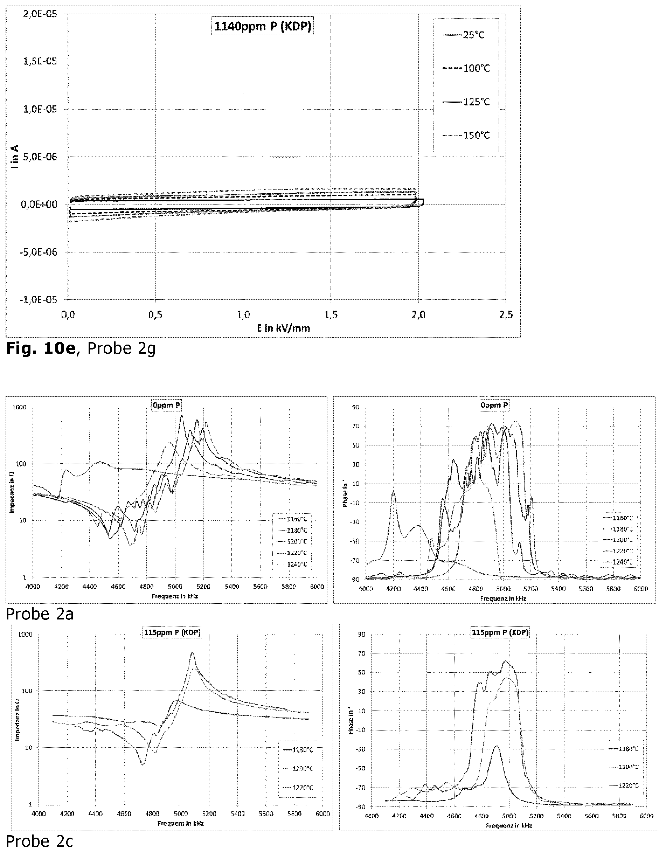

Die **Figuren 10a bis 10e** machen deutlich, daß bei erfindungsgemäßen Phosphoranteilen **≥250ppm** auch bei höheren Temperaturen eine wesentliche Verringerung des Probenstroms zu verzeichnen ist. Dadurch ist der Betrieb von Aktoren auch bei höheren Betriebstemperaturen möglich.

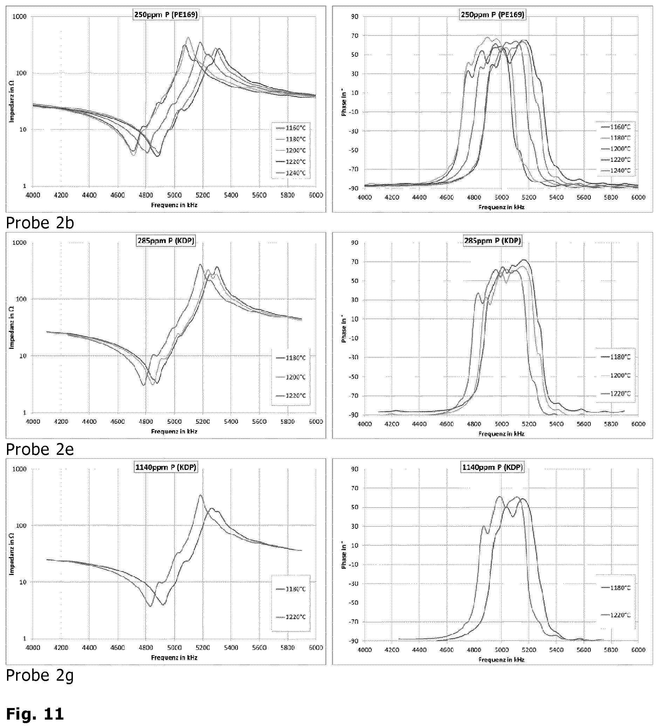

Die Streuung der Probeneigenschaften wird erheblich reduziert. Betrachtet man charakteristische Resonanzkurven von den bei unterschiedlichen Temperaturen gesinterten Proben, so fällt auf, dass bei erfindungsgemäßen Phosphoranteilen **≥250ppm** die Unterschiede zwischen den bei unterschiedlichen Temperaturen Tabelle 2 gesinterten Proben wesentlich reduziert werden und sich somit das Sinterintervallüberraschenderweise auf einen technologisch verwertbaren, leicht realisierbaren Temperaturbereich verbreitern lässt (Tabelle 3a, 3b, **Fig. 11**).

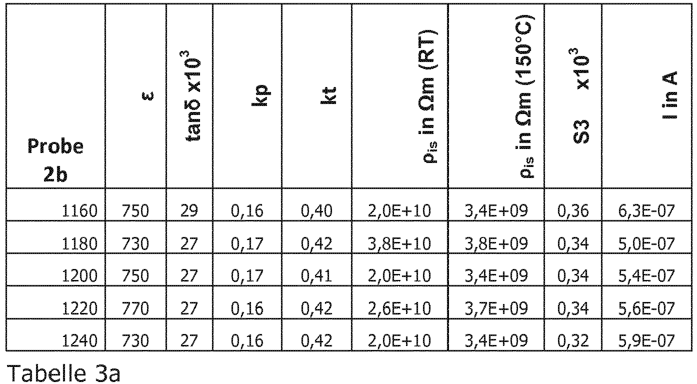

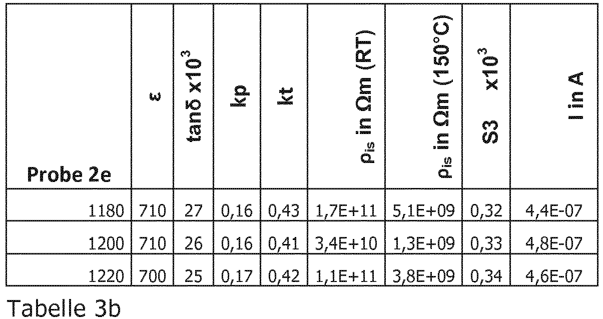

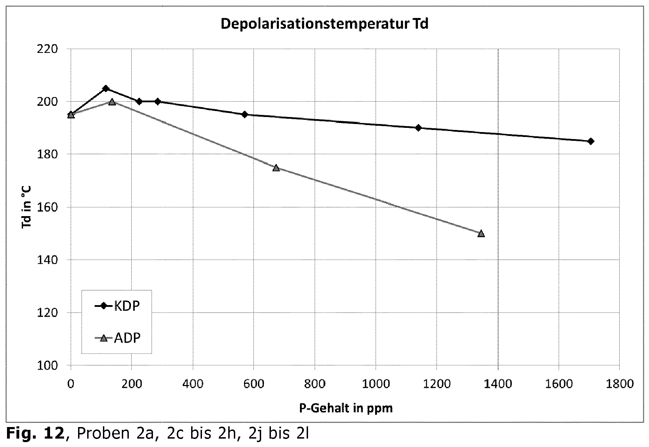

Überraschenderweise lässt sich die Depolarisationstemperatur durch Wahl des phosphorhaltigen Materials in einem breiten Bereich einstellen. **Fig. 12** (Proben 2a, 2c bis 2h, 2j bis 2l) zeigt die Depolarisationstemperatur Td, für unterschiedliche Phosphorquellen und -anteile. Damit eröffnet sich die Möglichkeit, die Depolarisationstemperatur anwendungsspezifisch zu variieren.

### Ausführungsbeispiel 2:

Die Proben 3, 4, 5b, 6 und 2n gemäß Tabelle 2 sind weitere Beispiele für erfindungsgemäße, großtechnisch anwendbare Modifizierung der Grundzusammensetzung **0,85(Bi0,5Na0,5)TiO3** - **0,12BaTiO3 -0,03SrTiO3.**

Als wesentlicher technologischer Vorteil ist anzusehen, dass in den Beispielen 3 und 5b das Material bis zum Feinmahlen ohne Phosphor prozessiert wurde und der Phosphor erst bei der Verschlickerung zur Sprühgranulierung zugesetzt wurde.

In den Beispielen 4, 6 erfolgte der Phosphor- Zusatz bei der Feinmahlung, im Beispiel 2n bei der organischen Verschlickerung zum Foliengießen.

Vorteilhaft ist, dass die großtechnische Materialverarbeitung unabhängig vom primären Formgebungsprozess (Pressen oder Foliengießen) einheitlich bis zur Feinmahlung erfolgen und somit die Art und Menge des Phosphorzusatzes dem jeweiligen Formgebungsprozess optimal angepasst werden kann.

Vorteilhaft kann aber auch die mögliche Kombination viskositätsbestimmender phosphorhaltiger Dispergatoren bzw. Bindemittel und weitgehend "viskositätsneutraler" Zusätze wie z.B. KDP oder ADP sein.

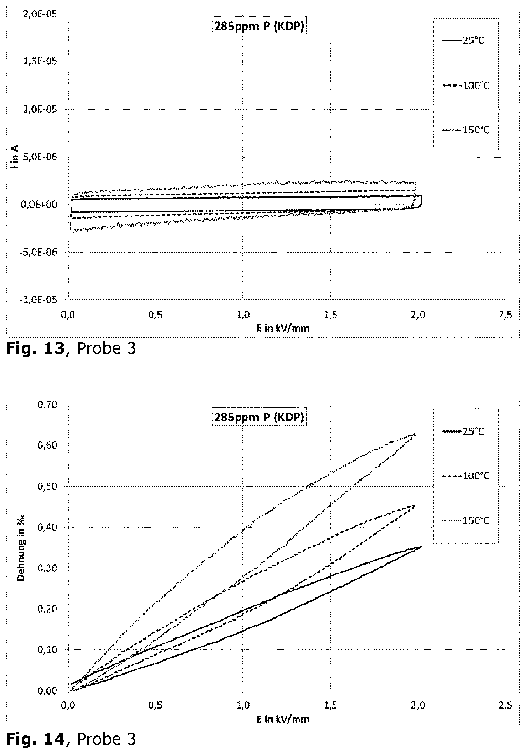

Die **Figuren 13 und 14****,** Probe 3 zeigen die elektromechanische Dehnung und den Probenstrom in Temperaturbereich von 25 bis 150°C für eine erfindungsgemäße Zusammensetzung.

### Ausführungsbeispiel 3:

Tabelle 2 enthält als weitere erfindungsgemäße Beispiele Variationen der Grundzusammensetzung **x(Bi0,5Na0,5)TiO3 - yBaTiO₃ - zSrTiO₃** bezüglich des BaTiO3 und SrTiO3- Anteils.

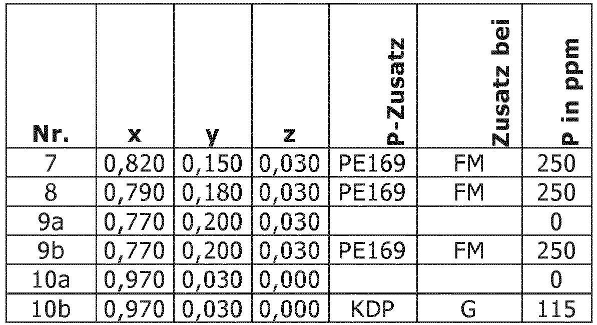

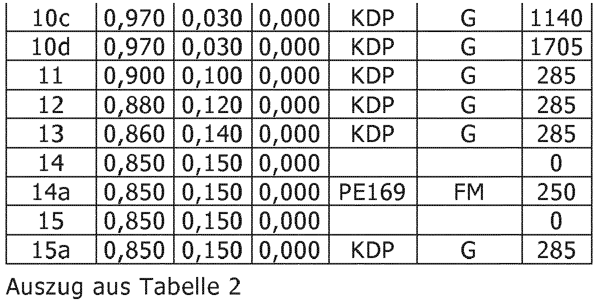

Im Bereich y≥ 0,10 verhält sich das Werkstoffsystem bezüglich der Phosphor-Modifizierung ähnlich wie die Grundzusammensetzung 0,85(Bi0,5Na0,5)TiO3 - 0,12BaTiO3 -0,03SrTiO3.

Der Bereich y< 0,10 erfordert Phosphor- Anteile im oberen beanspruchten Wertebereich.

## Patentansprüche

1. Bleifreier piezokeramischer Werkstoff auf Bismut-Natrium-Titanat (BNT)-Basis der Grundzusammensetzung
| | |
|---|---|
| x(Bi_{0,5}Na_{0,5})TiO₃ - yBaTiO₃ - zSrTiO₃ | mit x+y+z = 1 |
| und | 0<x<1, 0<y<1, 0≤z≤0,07 |
oder
| | |
|---|---|
| x(Bi_{0,5}Na_{0,5})TiO₃ - yBaTiO₃ - zCaTiO₃ | mit x+y+z = 1 |
| und | 0<x<1, 0<y<1, 0<z≤0,05 |
**gekennzeichnet durch**
die Zugabe eines phosphorhaltigen Materials in einer solchen Menge, dass die Konzentration von Phosphor im piezokeramischen Werkstoff bei 250 bis 2000 ppm liegt, wobei sich die Angabe ppm (parts per million) auf die Masse an Phosphor bezogen auf die Gesamtmasse der piezokeramischen Zusammensetzung bezieht.

2. Bleifreier piezokeramischer Werkstoff auf Bismut-Natrium-Titanat (BNT)-Basis gemäß Anspruch 1, wobei die Grundzusammensetzung
x(Bi_{0,5}Na_{0,5})TiO₃ - yBaTiO₃ - zSrTiO₃ mit y ≥ 0,1 und x+y+z = 1 oder
x(Bi_{0,5}Na_{0,5})TiO₃ - yBaTiO₃ - zCaTiO₃ mit y ≥ 0,1 und x+y+z = 1 ist.

3. Bleifreier piezokeramischer Werkstoff gemäß Anspruch 1 oder 2,
**dadurch gekennzeichnet, dass**
die phosphorhaltige Verbindung ein anorganisches Phosphat, Hydrogenphosphat oder Dihydrogenphosphat ist.

4. Bleifreier piezokeramischer Werkstoff gemäß einem der Ansprüche 1 bis 3,
**dadurch gekennzeichnet, dass**
die phosphorhaltige Verbindung ausgewählt ist aus der Gruppe, die aus KH₂PO₄,(NH₄)H₂PO₄ besteht.

5. Bleifreier piezokeramischer Werkstoff gemäß mindestens einem der Ansprüche 1 bis 4,
**dadurch gekennzeichnet, dass**
das phosphorhaltige Material in einer solchen Menge zugegeben wird, dass die Konzentration von Phosphor in dem bleifreien piezokeramischen Werkstoff 270 bis 1800 ppm beträgt.

6. Bleifreier piezokeramischer Werkstoff nach einem der Ansprüche 1 bis5,
**dadurch gekennzeichnet, dass**
die Grundzusammensetzung Zusätze in Form von Oxiden oder komplexen Perowskiten enthält.

7. Verfahren zur Herstellung eines bleifreien piezokeramischen Werkstoffs nach einem der vorangegangenen Ansprüche 1 bis 6,
**gekennzeichnet durch**
folgende Schritte:
- Herstellung einer Rohstoffmischung der Grundzusammensetzung,
- Herstellung eines Kalzinats der Grundzusammensetzung
- Feinmahlung des Kalzinats
- Herstellung eines Granulats insbesondere durch Sprühgranulierung oder Herstellung eines Gießschlickers für den Multilayer oder "Co-firng" Prozess
- Weiterverarbeitung in bekannter Weise einschließlich Sinterung in normaler Atmosphäre, wobei phosphorhaltige Zusätze bei der Feinvermahlung oder der Sprühgranulierung und/oder bei der Aufbereitung von Gießschlickern zugegeben werden.

8. Piezokeramischer Multilayeraktor auf der Basis eines bleifreien piezokeramischen Werkstoffs nach einem der Ansprüche 1 bis 6.

9. Piezokeramisches Bauelement, bevorzugt aufweisend mindestens einen piezokeramischen Körper mit mindestens zwei Elektroden, mehr bevorzugt in Form eines piezoelektrischen Ultraschallwandlers, auf der Basis eines bleifreien piezokeramischen Werkstoffs nach einem der Ansprüche 1 bis 6.

10. Verwendung eines phosphorhaltigen Materials in einem piezokeramischen Werkstoff auf Bismut-Natrium-Titanat (BNT)-Basis der Grundzusammensetzung
x(Bi_{0,5}Na_{0,5})TiO₃ - yBaTiO₃ - zSrTiO₃ mit x+y+z = 1 und 0<x<1, 0<y<1, 0≤z<0,07 oder
x(Bi_{0,5}Na_{0,5})TiO₃ - yBaTiO₃ - zCaTiO₃ mit x+y+z = 1 und 0<x<1, 0<y<1, 0<z≤0,05
zur Verminderung des Riesenkornwachstums, wobei das phosphorhaltige Material in einer solchen Menge eingesetzt wird, dass die Konzentration von Phosphor im piezokeramischen Werkstoff bei 250 bis 2000 ppm, stärker bevorzugt bei 270 bis 1800 ppm liegt, wobei sich die Angabe ppm (parts per million) auf die Masse an Phosphor bezogen auf die Gesamtmasse der piezokeramischen Zusammensetzung bezieht.

11. Verwendung gemäß Anspruch 10, wobei die Grundzusammensetzung x(Bi_{0,5}Na_{0,5})TiO₃ - yBaTiO₃ - zSrTiO₃ mit y ≥ 0,1 und x+y+z = 1 oder x(Bi_{0,5}Na_{0,5})TiO₃ - yBaTiO₃ - zCaTiO₃ mit y ≥ 0,1 und x+y+z = 1 ist.

12. Verwendung gemäß Anspruch 10 oder 11,
**dadurch gekennzeichnet, dass** die phosphorhaltige Verbindung ein anorganisches Phosphat, Hydrogenphosphat oder Dihydrogenphosphat ist.

13. Verwendung gemäß einem der Ansprüche 10 bis 12,
**dadurch gekennzeichnet, dass** die phosphorhaltige Verbindung ausgewählt ist aus der Gruppe, die aus KH₂PO₄,(NH₄)H₂PO₄ besteht.

## Claims

1. Lead-free piezoceramic material based on bismuth sodium titanate (BST) of the fundamental composition
| | |
|---|---|
| x(Bi_{0.5}Na_{0.5})TiO₃ - yBaTiO₃ - zSrTiO₃ | with x + y+ z = 1 |
| and | 0 < x < 1, 0 < y < 1, 0 ≤ z ≤ 0.07 |
or
| | |
|---|---|
| x(Bi_{0.5}Na_{0.5})TiO₃ - yBaTiO₃ - zCaTiO₃ | with x + y+ z = 1 |
| and | 0 < x < 1, 0 < y < 1, 0 ≤ z ≤ 0.05 |
**characterized by**
the addition of a phosphoric material in such an amount that the concentration of phosphorous in the piezoceramic material is at 250 to 2000 ppm, wherein the specification ppm (parts per million) relates to the mass of phosphorous in relation to the total mass of the piezoceramic composition.

2. Lead-free piezoceramic material based on bismuth sodium titanate (BST) according to claim 1, wherein the fundamental composition is x(Bi_{0.5}Na_{0.5})TiO₃ - yBaTiO₃ - zSrTiO₃ with y ≥ 0.1 and x + y + z = 1 or x(Bi_{0.5}Na_{0.5})TiO₃ - yBaTiO₃ - zCaTiO₃ with y ≥ 0.1 and x + y + z = 1.

3. Lead-free piezoceramic material according to claim 1 or 2,
**characterized in that**
the phosphoric compound is an inorganic phosphate, hydrogen phosphate, or dihydrogen phosphate.

4. Lead-free piezoceramic material according to anyone of claims 1 to 3,
**characterized in that**
the phosphoric compound is selected from the group consisting of KH₂PO₄, (NH₄)H₂PO₄.

5. Lead-free piezoceramic material according to at least one of claims 1 to 4,
**characterized in that**
the phosphoric material is added in such an amount that the concentration of phosphorous in the lead-free piezoceramic material is 270 to 1800 ppm.

6. Lead-free piezoceramic material according to anyone of claims 1 to 5,
**characterized in that**
the fundamental composition contains additives in the form of oxides or complex perovskites.

7. Method for producing a lead-free piezoceramic material according to anyone of the preceding claims 1 to 6,
**characterized by**
the following steps:
- producing a raw material mixture of the fundamental composition,
- producing a calcinate of the fundamental composition,
- finely grinding the calcinate,
- producing a granulate in particular by spray granulation or producing a casting slurry for the multilayer or "co-firing" process,
- further processing in a known manner including sintering in normal atmosphere, wherein phosphoric additives are added during the fine grinding or the spray granulation and/or during the preparation of casting slurries.

8. Piezoceramic multilayer actuator based on a lead-free piezoceramic material according to anyone of claims 1 to 6.

9. Piezoceramic component, preferably comprising at least one piezoceramic body having at least two electrodes, more preferably in the form of a piezoelectric ultrasonic transducer, based on a lead-free piezoceramic material according to anyone of claims 1 to 6.

10. Use of a phosphoric material in a piezoceramic material based on bismuth sodium titanate (BST) of the fundamental composition
x(Bi_{0.5}Na_{0.5})TiO₃ - yBaTiO₃ - zSrTiO₃ with x + y+ z = 1 and 0 < x < 1, 0 < y < 1, 0 ≤ z ≤ 0.07
or
x(Bi_{0.5}Na_{0.5})TiO₃ - yBaTiO₃ - zCaTiO₃ with x + y+ z = 1 and 0 < x < 1, 0 < y < 1, 0 ≤ z ≤ 0.05
to reduce the growth of giant grains, wherein the phosphoric material is used in such an amount that the concentration of phosphorous in the piezoceramic material is at 250 to 2000 ppm, more preferably at 270 to 1800 ppm, wherein the specification ppm (parts per million) relates to the mass of phosphorous in relation to the total mass of the piezoceramic composition.

11. Use according to claim 10, wherein the fundamental composition is
x(Bi_{0.5}Na_{0.5})TiO₃ - yBaTiO₃ - zSrTiO₃ with y ≥ 0.1 and x + y+ z = 1 or
x(Bi_{0.5}Na_{0.5})TiO₃ - yBaTiO₃ - zCaTiO₃ with y ≥ 0.1 and x + y+ z = 1.

12. Use according to claim 10 or 11,
**characterized in that**
the phosphoric compound is an inorganic phosphate, hydrogen phosphate, or dihydrogen phosphate.

13. Use according to anyone of claims 10 to 12,
**characterized in that**
the phosphoric compound is selected from the group consisting of KH₂PO₄, (NH₄)H₂PO₄.

## Revendications

1. Matière piézocéramique sans plomb à base de bismuth-sodium-titanate (BNT) de la composition de base
| | |
|---|---|
| x(Bi_{0,5}Na_{0,5})TiO₃ - yBaTiO₃ - zSrTiO₃ | avec x + y + z = 1 |
| et | 0 < x < 1, 0 < y < 1, 0 ≤ z ≤ 0,07 |
ou
| | |
|---|---|
| x(Bi_{0,5}Na_{0,5})TiO₃ - yBaTiO₃ - zCaTiO₃ | avec x + y + z = 1 |
| et | 0 < x < 1, 0 < y < 1, 0 ≤ z ≤ 0,05 |
**caractérisée par**
l'ajout d'un matériau contenant du phosphore dans une quantité telle que la concentration de phosphore dans la matière piézocéramique est de 250 à 2000 ppm, l'indication ppm (parts per million) se référant à la masse de phosphore par rapport à la masse totale de la composition piézocéramique.

2. Matière piézocéramique sans plomb à base de bismuth-sodium-titanate (BNT) selon la revendication 1, dans laquelle la composition de base est
x(Bi_{0,5}Na_{0,5})TiO₃ - yBaTiO₃ - zSrTiO₃ avec y ≥ 0,1 et x + y + z = 1
ou
x(Bi_{0,5}Na_{0,5})TiO₃ - yBaTiO₃ - zCaTiO₃ avec y ≥ 0,1 et x + y + z = 1.

3. Matière piézocéramique sans plomb selon la revendication 1 ou 2,
**caractérisée en ce que**
le composé contenant du phosphore est un phosphate, hydrogène-phosphate ou dihydrogène-phosphate inorganique.

4. Matière piézocéramique sans plomb selon l'une des revendications 1 à 3,
**caractérisée en ce que**
le composé contenant du phosphore est choisi parmi le groupe constitué de KH₂PO₄, (NH₄)H₂PO₄.

5. Matière piézocéramique sans plomb selon l'une au moins des revendications 1 à 4,
**caractérisée en ce que**
le matériau contenant du phosphore est ajouté dans une quantité telle que la concentration de phosphore dans la matière piézocéramique sans plomb est de 270 à 1800 ppm.

6. Matière piézocéramique sans plomb selon l'une des revendications 1 à 5,
**caractérisée en ce que**
la composition de base comprend des additifs sous forme d'oxydes ou de pérovskites complexes.

7. Procédé de préparation d'une matière piézocéramique sans plomb selon l'une des revendications précédentes 1 à 6,
**caractérisé par** les étapes suivantes consistant à :
- préparer un mélange de matières premières de la composition de base,
- préparer un calcinat de la composition de base,
- broyer finement le calcinat,
- préparer un granulé en particulier par granulation par pulvérisation ou préparer une barbotine coulable pour le processus multicouche ou "co-firing" (co-cuisson),
- continuer la préparation de façon connue, y compris le frittage sous atmosphère normale, des additifs contenant du phosphores étant ajoutés lors du broyage fin ou de la granulation par pulvérisation et/ou lors de la préparation de barbotines coulables.

8. Actionneur multicouche piézocéramique à base d'une matière piézocéramique sans plomb selon l'une des revendications 1 à 6.

9. Composant piézocéramique, comprenant de préférence au moins un corps piézocéramique pourvu d'au moins deux électrodes, de manière plus préférée sous la forme d'un transducteur ultrasonique piézoélectrique sur la base d'une matière piézocéramique sans plomb selon l'une des revendications 1 à 6.

10. Utilisation d'un matériau contenant du phosphore dans une matière piézocéramique à base de bismuth-sodium-titanate (BNT) de la composition de base
x(Bi_{0,5}Na_{0,5})TiO₃ - yBaTiO₃ - zSrTiO₃ avec x + y + z = 1 et
0 < x < 1, 0 < y < 1, 0 ≤ z ≤ 0,07
ou
x(Bi_{0,5}Na_{0,5})TiO₃ - yBaTiO₃ - zCaTiO₃ avec x + y + z = 1 et
0 < x < 1, 0 < y < 1, 0 ≤ z ≤ 0,05
pour réduire la croissance de grains géants,
dans laquelle le matériau contenant du phosphore est ajouté dans une quantité telle que la concentration de phosphore dans la matière piézocéramique est de 250 à 2000 ppm, de préférence de 270 à 1800 ppm, l'indication ppm (parts per million) se référant à la masse de phosphore par rapport à la masse totale de la composition piézocéramique.

11. Utilisation selon la revendication 10, dans laquelle la composition de base est
x(Bi_{0,5}Na_{0,5})TiO₃ - yBaTiO₃ - zSrTiO₃ avec y ≥ 0,1 et x + y + z = 1
ou
x(Bi_{0,5}Na_{0,5})TiO₃ - yBaTiO₃ - zCaTiO₃ avec y ≥ 0,1 et x + y + z = 1.

12. Utilisation selon la revendication 10 ou 11,
**caractérisée en ce que**
le composé contenant du phosphore est un phosphate, hydrogène-phosphate ou dihydrogène-phosphate inorganique.

13. Utilisation selon l'une des revendications 10 à 12,
**caractérisée en ce que**
le composé contenant du phosphore est choisi parmi le groupe constitué de KH₂PO₄, (NH₄)H₂PO₄.
